# EUROPÄISCHE PATENTSCHRIFT

(11) **EP 3 339 085 B1**
(45) Veröffentlichungstag und Bekanntmachung des Hinweises auf die Patenterteilung: **19.06.2019**
(21) Anmeldenummer: 16306743.2
(22) Anmeldetag: 20.12.2016
(51) Int. Cl.: B60L 11/18, H01B 12/16, H02G 15/34, F16L 59/065, F16L 59/14

(54) **ANORDNUNG ZUR STROMVERSORGUNG EINES MIT EINEM ELEKTROMOTOR AUSGERÜSTETEN KRAFTFAHRZEUGS**
ASSEMBLY FOR SUPPLYING POWER TO A MOTOR VEHICLE WITH AN ELECTRIC MOTOR
SYSTÈME D'ALIMENTATION EN COURANT D'UN VÉHICULE AUTOMOBILE ÉQUIPÉ D'UN MOTEUR ÉLECTRIQUE

(43) Veröffentlichungstag der Anmeldung: 27.06.2018
(73) Patentinhaber: Nexans, 92400 Courbevoie (FR)
(72) Erfinder: SOIKA, Rainer, 78166 Donaueschingen (DE); STEINBERG, Helmut, 92721 Störnstein (DE)
(74) Vertreter: Laget, Jean-Loup

(56) Entgegenhaltungen:
- WO-A2-02/25672
- CN-A- 105 845 271
- DE-A1- 1 948 520
- DE-U1-202009 010 275
- US-A1- 2005 079 980
- MICHAEL J JEFFERIES ET AL: "High-Voltage Testing of a High-Capacity, Liquid-Nitrogen Cooled Cable", IEEE TRANSACTIONS ON POWER APPARATUS AND SYSTEMS, IEEE INC. NEW YORK, US, Bd. 82, Nr. 2, März 1973 (1973-03), Seiten 514-519, XP011161116, ISSN: 0018-9510

## Beschreibung

Die Erfindung bezieht sich auf eine Anordnung zur Stromversorgung eines mit einem Elektromotor ausgerüsteten Kraftfahrzeugs gemäß dem Oberbegriff des Patentanspruchs 1.

Eine solche Anordnung geht beispielsweise aus der CN 105 845 271 A hervor.

Kraftfahrzeuge - im Folgenden kurz als "Fahrzeuge" bezeichnet -, welche als Antrieb einen Elektromotor aufweisen, sind seit Jahren bekannt und weltweit im Einsatz. Dabei kann der Elektromotor einziger Antrieb für ein Fahrzeug sein. In der ebenfalls bekannten Hybridtechnik kann aber neben dem Elektromotor auch ein Verbrennungsmotor in einem Fahrzeug angeordnet sein. Beide Antriebe werden in der Regel wahlweise getrennt voneinander eingesetzt. Sie können aber auch - beispielsweise auf Bergstrecken - gleichzeitig verwendet werden.

Für den Betrieb des Elektromotors ist in den Fahrzeugen mindestens eine wiederaufladbare elektrische Batterie vorhanden. Für einen entsprechenden Ladevorgang sind Ladestationen bekannt und ebenfalls weltweit im Einsatz. Die Ladestationen sind mit einem elektrischen Kabel ausgerüstet, das an seinem freien Ende einen Stecker zum Anschluß an ein Fahrzeug hat. Die in der Ladestation zur Verfügung gestellte elektrische Spannung liegt bei modernen Anlagen bei 48 Volt. Von den Leitern der an die Ladestation angeschlossenen Leitung wird elektrischer Strom in Höhe von beispielsweise 5 kA übertragen. Die elektrisch leitenden Querschnitte der Leiter müssen dementsprechend groß sein. Das erfordert einen erheblichen Aufwand an elektrisch leitendem Material, wie Kupfer oder Aluminium.

Die an eine Ladestation angeschlossene Leitung hat daher ein erhebliches Gewicht. Ihre Handhabung zur Verbindung mit dem komplementären Kupplungsteil des Fahrzeugs kann dementsprechend zu Problemen führen.

Die eingangs erwähnte CN 105 845 271 A bezieht sich auf eine Ladestation zur Stromversorgung von Kraftfahrzeugen mit einem Elektromotor, in welcher ein Behälter mit flüssigem Stickstoff angeordnet ist, in welchen eine Versorgungsleitung eintaucht. An die Versorgungsleitung ist über eine Steckverbindung ein supraleitfähiges Kabel angeschlossen, das zusammen mit anderen Kabeln bzw. Leitungen in einem aus Isoliermaterial bestehenden Rohr angebracht ist. Der flüssige Stickstoff wird in das Rohr eingeleitet, so dass die umschlossenen Kabel auf -195,5 °C abgekühlt werden. Das supraleitfähige Kabel geht dadurch in den supraleitfähigen Zustand über. Die Patentanmeldung US2005/079980 A1 (Hirose) beschreibt einen ähnlichen supraleitenden Kabel.

Der Erfindung liegt die Aufgabe zugrunde, die eingangs geschilderte Anordnung so zu gestalten, dass die Handhabung der an eine Ladestation angeschlossenen Leitung und deren Anschluß an ein Fahrzeug für einen Ladevorgang vereinfacht ist. Diese Aufgabe wird entsprechend den kennzeichnenden Merkmalen des Patentanspruchs 1 gelöst.

Der Wert des elektrischen Widerstandes der elektrischen Leiter beträgt bei einer Temperatur von -160°C nur noch etwa 10% des Wertes bei normaler Umgebungstemperatur. Der Aufwand an Leitermaterial für die elektrischen Leiter der Leitung kann daher wesentlich reduziert werden. Einschließlich des die Leiter umgebenden isolierten Rohres beträgt das Gewicht der Leitung nur noch etwa 20 % einer herkömmlichen Leitung. Sie kann daher einfacher und mit wesentlich verringertem Kraftaufwand gehandhabt werden.

Das Rohr der Leitung ist zur verbesserten Wärmeisolierung zu einem Kryostat erweitert, da um dasselbe unter Einschluß einer thermischen Isolierung ein ebenfalls aus Metall bestehendes, flexibles Außenrohr angeordnet ist. Der Zwischenraum zwischen Rohr und Außenrohr ist evakuiert. Über dem Außenrohr wird zweckmäßig eine geschlossene Schicht aus isolierendem Material angebracht. Beide Rohre sind zur Verbesserung ihrer Biegbarkeit quer zu ihrer Längsrichtung gewellt, und zwar wendelförmig oder ringförmig.

Das tiefgekühlte Medium wird mittels einer Pumpe durch das Rohr bewegt. Die Pumpe wird vorzugsweise so eingestellt, dass das tiefgekühlte Medium sehr langsam durch das Rohr fließt, beispielsweise mit einer Geschwindigkeit von beispielsweise etwa 5 Meter pro Minute.

Für das tiefgekühlte Medium ist am von der Ladestation abgewandten Ende an das Rohr ein Leerrohr angeschlossen, durch welches das tiefgekühlte Medium zur Ladestation zurückgeführt wird. In der Ladestation ist ein Kühlaggregat angeordnet, durch welches das über das Leerrohr rückgeführte tiefgekühlte Medium wieder auf die erforderliche Betriebstemperatur abgekühlt und dem Vorratsbehälter zugeführt wird.

Ausführungsbeispiele des Erfindungsgegenstandes sind in den Zeichnungen dargestellt.

Es zeigen:
Fig. 1 in schematischer Darstellung eine Ladestation für elektrischen Strom.
Fig. 2 einen Abschnitt einer an die Ladestation angeschlossenen Leitung im Schnitt.
Fig. 3 eine gegenüber Fig. 2 ergänzte Leitung.
Fig. 4 eine Einzelheit der Anordnung nach der Erfindung in rein schematischer Darstellung.

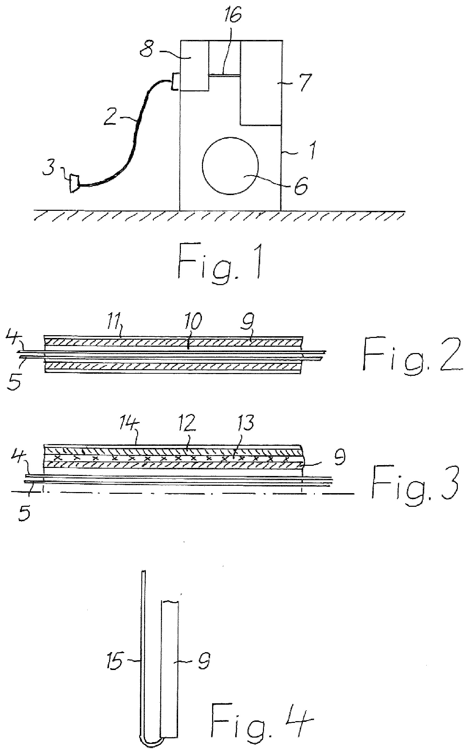

In Fig. 1 ist schematisch eine Ladestation 1 dargestellt, die zum Wiederaufladen einer Batterie eines Fahrzeugs dient. Eine solche Ladestation ist in bekannter Technik beispielsweise im Bereich von Tankstellen oder in Parkhäusern oder Parkbuchten aufgebaut.

An die Ladestation 1 ist eine elektrische Leitung 2 angeschlossen, an deren freiem Ende ein elektrisches Kupplungsteil 3 angebracht ist. Das Kupplungsteil 3 ist mit Vorteil ein Stecker, der mit einer im Fahrzeug vorhandenen Buchse als komplementäres Kupplungsteil verbunden werden kann. In der Leitung 2 sind mindestens zwei isolierte elektrische Leiter 4 und 5 (Fig. 2 und 3) angeordnet. Elektrische Bauteile der Ladestation, wie beispielsweise ein Wechselspannungs/Gleichspannungs-Wandler, sind in Fig. 1 durch einen Kreis 6 schematisch angedeutet. In der Ladestation 1 sind ein Vorratsbehälter 7 und im dargestellten Ausführungsbeispiel außerdem ein Kühlaggregat 8 angebracht.

Die Leitung 2 weist gemäß Fig. 2 die beiden isolierten elektrischen Leiter 4 und 5 auf. Sie bestehen beispielsweise aus Kupfer oder Aluminium. Die beiden Leiter 4 und 5 sind auf ihrer ganzen Länge von einem gut biegbaren, aus Metall bestehenden Rohr 9 umgeben, das neben den beiden Leitern 4 und 5 auch einen auf seiner ganzen axialen Länge vorhandenen Hohlraum 10 umschließt. Das Rohr 9 ist auf seiner ganzen Länge von einer thermischen Isolierung 11 umgeben. Es ist zur Verbesserung seiner Biegbarkeit quer zu seiner Längsrichtung gewellt, und zwar wendelförmig oder ringförmig.

Durch den Hohlraum 10 wird permanent ein fließfähiges, tiefgekühltes Medium - im Folgenden nur noch "Medium" genannt - geleitet, das auf eine Temperatur von mindestens -160 °C abgekühlt ist. Als Medium wird mit Vorteil Stickstoff eingesetzt. Das Medium ist in dem Vorratsbehälter 7 enthalten, der thermisch isoliert in der Ladestation 1 angeordnet ist. Er ist von außen zugänglich, so dass das Medium von einem Lieferanten im Bedarfsfall ständig ergänzt werden kann.

Das Medium wird mittels einer nicht mit dargestellten Pumpe aus dem Vorratsbehälter 7 abgezogen und in das Rohr 9 mit einer niedrigen Geschwindigkeit hineingepumpt, so dass es durch dasselbe hindurchbewegt wird. Die beiden Leiter 4 und 5 haben einen elektrisch leitenden Querschnitt, der etwa 10 % des Querschnitts entspricht, der bei herkömmlichen Leitern und üblicher Umgebungstemperatur von beispielsweise 20 °C zum Übertragen von elektrischen Strömen mit sehr hoher Stromstärke benötigt wird. Das sind Ströme von beispielsweise 5 kA.

Durch das Medium werden die Leiter 4 und 5 auf eine der Temperatur desselben von mindestens -160 °C entsprechende Temperatur abgekühlt. Ihr elektrischer Widerstand geht dadurch auf etwa 10 % des bei Umgebungstemperatur bestehenden Wertes zurück. Der Querschnitt der Leiter 4 und 5 kann dementsprechend auf 10 % von Leitern reduziert werden, die bei Umgebungstemperatur eingesetzt werden. Die Leitung 2 wird entsprechend leichter. Ihr Gewicht einschließlich des Rohres 9 beträgt etwa 20 % einer herkömmlichen Leitung. Die Leitung 2 kann dementsprechend leichter gehandhabt werden.

Das Rohr 9 ist entsprechend Fig. 3 zu einem in der Kryotechnik bekannten Kryostat ergänzt. Der Innenraum des Rohres 9 wird dadurch verbessert gegen Wärmeinwirkung von außen geschützt. Das im Rohr 9 bewegte Medium behält dann seine niedrige Temperatur über einen längeren Zeitraum und es kann entsprechend langsamer durch das Rohr 9 bewegt werden.

Der erwähnte Kryostat ist durch ein flexibles Außenrohr 12 realisiert, welches das Rohr 9 unter Einschluß einer Isolierung 13 auf seiner ganzen Länge umgibt. Das Außenrohr 12 besteht ebenfalls aus Metall und es ist ebenfalls quer zu seiner Längsrichtung gewellt. Über dem Außenrohr 12 ist eine geschlossene Schicht 14 aus einem isolierenden Material angebracht. Der Raum zwischen dem Rohr 9 und dem Außenrohr 12 ist evakuiert.

Das Medium wird durch den Hohlraum 10 des Rohres 9 bewegt. An das Rohr 9 bzw. an seinen Hohlraum 10 ist ein Leerrohr 15 angeschlossen, das bis in die Ladestation 1 ragt und durch welches das Medium bis in die Ladestation 1 zurückgeführt wird. Es ist in der Ladestation 1 an das Kühlaggregat 8 angeschlossen, in welchem es wieder auf seine Betriebstemperatur abgekühlt wird. Es kann dann über eine Rohrleitung 16 in den Vorratsbehälter 7 geleitet werden.

## Patentansprüche

1. Anordnung zur Stromversorgung eines mit einem Elektromotor ausgerüsteten Kraftfahrzeugs, in dem mindestens eine wiederaufladbare elektrische Batterie angeordnet ist, an welche der Elektromotor angeschlossen ist, zu die Anordnung gehört:
eine ortsfeste, mit einer elektrischen Stromquelle ausgerüstete Ladestation (1), an die eine elektrische Leitung mit mindestens zwei gegeneinander isolierten elektrischen Leitern angeschlossen ist, an deren freiem Ende ein Teil einer elektrischen Kupplung zum Anschluß an ein am bzw. im Kraftfahrzeug vorhandenes komplementäres Kupplungsteil angebracht ist, das elektrisch leitend mit der Batterie verbunden ist, bei welcher die elektrische Leitung (2) auf ihrer ganzen axialen Länge von einem rundum geschlossenen Rohr (9) umgeben ist, das auf seiner ganzen axialen Länge neben der Leitung einen Hohlraum umschließt, bei welcher in dem von dem Rohr (9) umschlossenen Raum ein fließfähiges, auf eine Temperatur von mindestens -160 °C tiefgekühltes Medium enthalten ist und bei welcher in der Ladestation (1) ein einen Vorrat des tiefgekühlten Mediums enthaltender, thermisch isolierter Vorratsbehälter (7) angeordnet ist, an den das Rohr (9) angeschlossen ist,
**dadurch gekennzeichnet,**
- **dass** das Rohr (9) ein thermisch isoliertes und flexibles Rohr aus Metall ist,
- **dass** das Rohr (9) unter Einschluß einer thermischen Isolierung (13) von einem flexiblen, ebenfalls aus Metall bestehenden Außenrohr (12) umgeben ist,
- **dass** der Raum zwischen Rohr (9) und Außenrohr (12) evakuiert ist,
- **dass** das Rohr (9) und das Außenrohr (12) quer zu ihrer Längsrichtung gewellt sind,
- **dass** in der Ladestation (1) eine Pumpe zur Bewegung des tiefgekühlten Mediums durch das Rohr (9) angeordnet ist und
- **dass** das Rohr (9) mit einem Leerrohr (15) zur Rückführung des tiefgekühlten Mediums zur Ladestation (1) ausgerüstet ist.

2. Anordnung nach Anspruch 1, **dadurch gekennzeichnet, dass** in der Ladestation (1) ein Kühlaggregat (8) angeordnet ist, an welches das Leerrohr (15) angeschlossen ist, und das über eine Rohrleitung (16) mit dem Vorratsbehälter (7) verbunden ist.

## Claims

1. An arrangement for the power supply of a motor vehicle equipped with an electric motor, in which at least one rechargeable electric battery is arranged, to which the electric motor is connected, part of which arrangement is:
A stationary charging station (1) equipped with an electrical power source, to which an electrical line with at least two electrical conductors insulated against each other is connected, to the free end of which a part of an electrical coupling for connecting to a complementary coupling part present on or in the motor vehicle is attached, which is connected electrically conductively to the battery, in which the electrical line (2) is surrounded along its entire axial length by a tube (9) closed all around, which surrounds a cavity next to the line along its entire axial length, in which in the space surrounded by the tube (9) a flowable medium deep-frozen at a temperature of at least -160 °C is contained and in which in the charging station (1) a thermally insulated storage container (7) containing a supply of the deep-frozen medium is arranged, to which the tube (9) is connected,
**characterized in**
- **that** the tube (9) is a thermally insulated and flexible tube made of metal,
- **that** the tube (9) including a thermal insulation (13) is surrounded by a flexible outer tube (12) also made of metal,
- **that** the space between tube (9) and outer tube (12) is evacuated,
- **that** the tube (9) and the outer tube (12) are corrugated transversely to their longitudinal direction,
- **that** in the charging station (1) a pump is arranged for moving the deep-frozen medium through the tube (9) and
- **that** the tube (9) is equipped with an empty tube (15) for returning the deep-frozen medium to the charging station (1).

2. An arrangement according to Claim 1, **characterized in that** in the charging station (1) a cooling unit (8) is arranged to which the empty tube (15) is connected, and which is connected via a pipeline to the storage container (7).

## Revendications

1. Dispositif d'alimentation électrique d'un véhicule équipé d'un moteur électrique, dans lequel est disposée au moins une batterie électrique rechargeable, à laquelle est raccordé le moteur électrique auquel, ce dispositif comprenant :
une station de charge fixe (1) munie d'une source de courant électrique, à laquelle est raccordée une ligne électrique avec au moins deux conducteurs électriques isolés entre eux, à l'extrémité desquels est montée une partie d'un couplage électrique pour le raccordement à une ou dans la partie de couplage complémentaire existant sur ou dans le véhicule, qui est reliée de manière électro-conductrice avec la batterie, la ligne électrique (2) étant entourée, sur toute sa longueur axiale, par un tube (9) fermé de tous côtés, qui entoure, sur toute sa longueur axiale, en plus de la ligne, une cavité, moyennant quoi, dans l'espace entouré par le tube (9), est contenu un milieu fluide, refroidi à une température d'au moins -160 °C et, dans la station de charge (1) est disposé un réservoir (7) thermiquement isolé, contenant une réserve de milieu refroidi, auquel est raccordé le tube (9),
**caractérisé en ce que**
- le tube (9) est un tube thermiquement isolé et flexible en métal,
- le tube (9) est entouré d'un tube externe (12), également constitué de métal, en intégrant une isolation thermique (13),
- un vide est effectué dans l'espace entre le tube (9) et le tube externe (12),
- le tube (9) et le tube externe (12) sont ondulés transversalement par rapport à la direction longitudinale,
- dans la station de charge (1) est disposée une pompe pour le déplacement du milieu refroidi à travers le tube (9) et
- le tube (9) est équipé d'un tube vide (15) pour le retour du milieu refroidi vers la station de charge (1).

2. Dispositif selon la revendication 1, **caractérisé en ce que**, dans la station de charge (1) est disposé un agrégat de refroidissement (8) auquel le tube vide (15) est raccordé, et qui est relié par l'intermédiaire d'une conduite tubulaire (16) avec le réservoir (7).
